# EUROPEAN PATENT APPLICATION

(11) **EP 4 184 553 A1**
(43) Date of publication of application: **24.05.2023**
(21) Application number: 22150441.8
(22) Date of filing: 06.01.2022
(51) Int. Cl.: H01L 21/20, C30B 25/00

(54) **METHOD FOR GROWING NITRIDE FILM**

(30) Priority: 19.11.2021 KR 20210160047
(71) Applicant: Lumigntech Co., Ltd., Gyeonggi-Do 14322 (KR)
(72) Inventor: LEE, Hae Yong, 14306 Gwangmyeong-si (KR); CHOI, Young Jun, 06715 Seoul (KR); OH, Hae Gon, 14272 Gwangmyeong-si (KR)
(74) Representative: Michalski Hüttermann & Partner Patentanwälte mbB

(57) **Abstract**

A method for growing a nitride film in accordance with an exemplary embodiment includes charging a substrate into a growth space, and growing a nitride film on the substrate, wherein the growing of a nitride film may include reacting a first reaction gas with a source raw material to supply a generated gas to the growth space, supplying a second reaction gas to the growth space, and supplying an oxygen-containing gas and a hydrogen-containing gas to the growth space. Accordingly, according to exemplary embodiments, even when a nitride film is formed thin, it is possible to planarize the upper surface of the nitride film. Accordingly, it is possible to reduce process time required to grow or form the nitride film until the upper surface thereof is planarized, and thus, there is an effect of improving the production rate.

## Description

### BACKGROUND

The present disclosure relates to a method for growing a nitride film, and more particularly, to a method for growing a nitride film in which the nitride film may be grown thin on a substrate having a protrusion portion, that is, a patterned sapphire substrate (PSS), yet the upper surface of the nitride film may be planarized.

A nitride-based light emitting diode is manufactured by growing a nitride semiconductor thin film, e.g., an aluminum nitride (AlN) film, on a sapphire substrate. At this time, in order to improve the extraction efficiency of light emitted to the outside, a substrate including a plurality of protrusion portions, which is commonly known as a patterned sapphire substrate (PSS), is used, and the AlN film is grown on the substrate.

Meanwhile, in order to improve the quality or light emitting efficiency of the light emitting diode, it is necessary to planarize the upper surface of the AlN film formed on the substrate. However, the substrate on which the AlN film is prepared to include the plurality of protrusion portions, the AlN film needs to be formed thick to allow the upper surface thereof to be planarized. That is, in order to planarize the upper surface, the AlN film needs to be formed thick. Accordingly, there is a problem in that it takes a long time to grow the AlN film.

### (Prior Art Document)

(Patent Document 1) Korean Patent Laid-open Publication 10-2016-0122118

### SUMMARY

The present disclosure provides a method for growing a nitride film capable of reducing the growth time of the nitride film.

The present disclosure also provides a method for growing a nitride film, the method capable of growing the nitride film to a thin thickness on a substrate having a protrusion portion, that is, a patterned sapphire substrate (PSS), and planarizing the upper surface of the nitride film.

In accordance with an exemplary embodiment, a method for growing a nitride film includes charging a substrate into a growth space, and growing a nitride film on the substrate, wherein the growing of a nitride film may include reacting a first reaction gas with a source raw material and supplying a generated gas to the growth space, supplying a second reaction gas to the growth space, and supplying an oxygen-containing gas and a hydrogen-containing gas to the growth space.

The method may further include adjusting the temperature inside the growth space before the charging of a substrate into the growth space, and supplying the second reaction gas to the growth space in a first supply amount to nitride the substrate before the growing of a nitride film.

In the reacting of the first reaction gas with the source raw material, the method may further include supplying the first reaction gas into a receiving part which is installed on one side of the growth space and in which the source raw material is received, and supplying the first reaction gas to the receiving part in a first supply amount before the growing of a nitride film.

In the growing of a nitride film, the supplying of the first reaction gas to the receiving part may include supplying the first reaction gas in a second supply amount greater than the first supply amount, and supplying the first reaction gas in a third supply amount greater than the second supply amount.

In the growing of a nitride film, the supplying of the second reaction gas to the growth space may include supplying the second reaction gas in a second supply amount less than the first supply amount, and supplying the second reaction gas in a third supply amount less than the first supply amount and greater than the second supply amount.

In the supplying of the oxygen-containing gas to the growth space, the volume ratio of the oxygen-containing gas in the total volume of gases supplied to the growth space may be approximately 0.01 vol% to approximately 0.1 vol%.

In the supplying of the oxygen-containing gas to the growth space, the oxygen-containing gas may be supplied from the start of the charging of the substrate to the growth space to the end of the growing of the nitride film.

In the supplying of the oxygen-containing gas to the growth space, the oxygen-containing gas may be supplied in the same amount from the start of the charging of the substrate to the growth space to the end of the growing of the nitride film.

In the supplying of the hydrogen-containing gas to the growth space, the volume ratio of the hydrogen-containing gas in the total volume of gases supplied to the growth space may be approximately 0.7 vol% to approximately 7 vol%.

In the supplying of the hydrogen-containing gas to the growth space, when the second reaction gas is supplied to the growth space in the third supply amount, the hydrogen-containing gas may be supplied to the growth space.

The preparing of the substrate may include manufacturing a substrate including a base and a plurality of protrusion portions which protrude upward from the base, wherein an upper surface of the protrusion portion, which is a surface opposite to the base, may have a length greater than 0.

The preparing of the substrate may include manufacturing a substrate including a base, a plurality of holes disposed spaced apart from each other above the base, and protrusion portions provided above the base to fill a gap between the plurality of holes, wherein on an upper surface of the protrusion portion, which is a surface opposite to the base, the length between the holes may be at least greater than 0.

The nitride film may include any one of AlN and GaN films, the first reaction gas may contain HCl, and the second reaction gas may contain NH₃, and the source raw material may include any one of a metal containing Al and a metal containing Ga.

The nitride film may be grown to have a thickness of approximately 2 µm to approximately 4.5 µm.

### BRIEF DESCRIPTION OF THE DRAWINGS

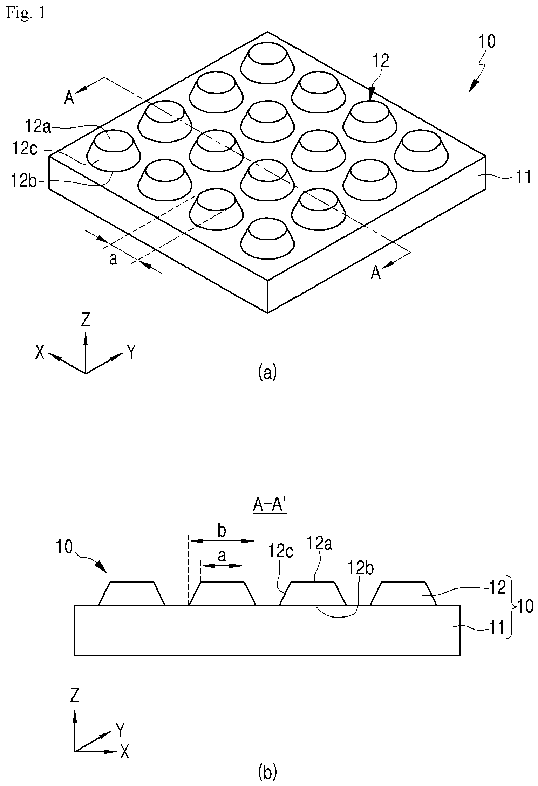

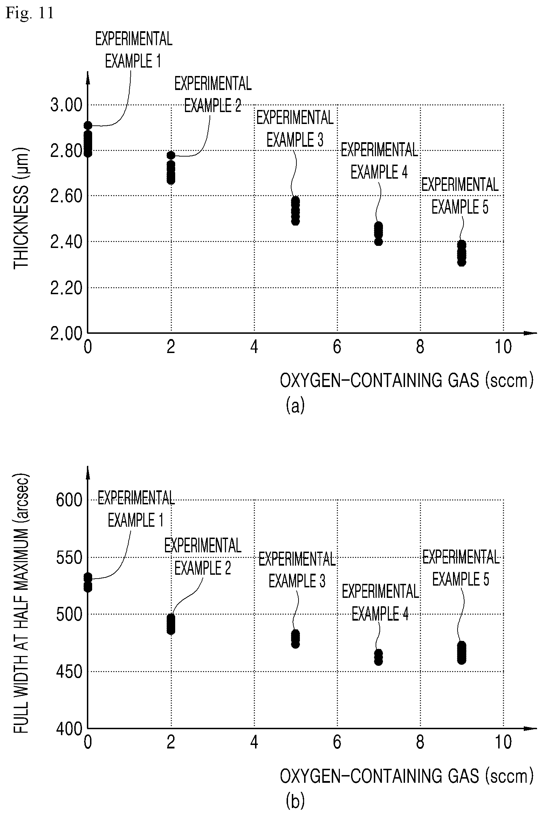

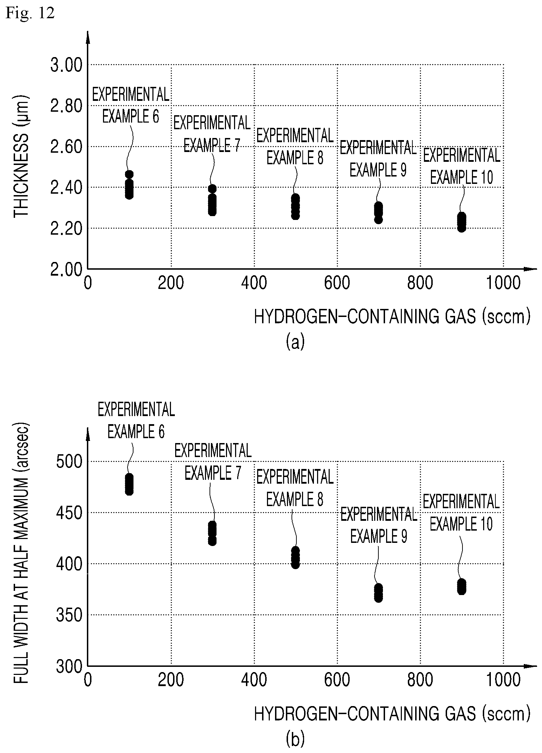

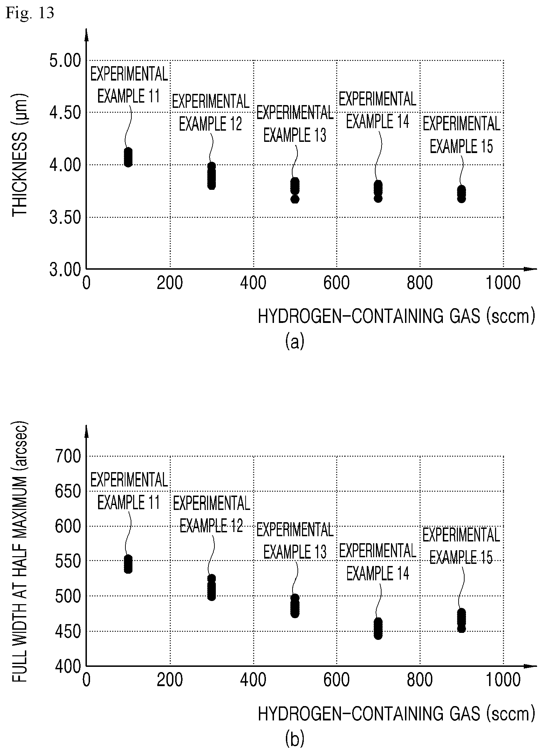

Exemplary embodiments can be understood in more detail from the following description taken in conjunction with the accompanying drawings, in which:
(a) of FIG. 1 is a three-dimensional view illustrating a substrate in accordance with an exemplary embodiment;
(b) of FIG. 1 is a cross-sectional view taken along A-A' of (a) of FIG. 1;
FIG. 2 is a scanning electron microscope (SEM) photograph of a cross-section of a substrate in accordance with an exemplary embodiment;
FIG. 3 is a view for describing a process in which a nitride film is grown on a substrate in accordance with an exemplary embodiment;
FIG. 4 is a scanning electron microscope (SEM) photograph of a cross-section of a nitride film grown on a substrate in accordance with an exemplary embodiment;
(a) of FIG. 5 is a three-dimensional view illustrating a substrate in accordance with another exemplary embodiment;
(b) of FIG. 5 is a cross-sectional view taken along B-B' of (a) of FIG. 5;
(a) of FIG. 6 is a scanning electron microscope (SEM) photograph of a cross-section of a substrate in accordance with another exemplary embodiment;
(b) of FIG. 6 is a scanning electron microscope (SEM) photograph taken from the above of a substrate in accordance with another exemplary embodiment;

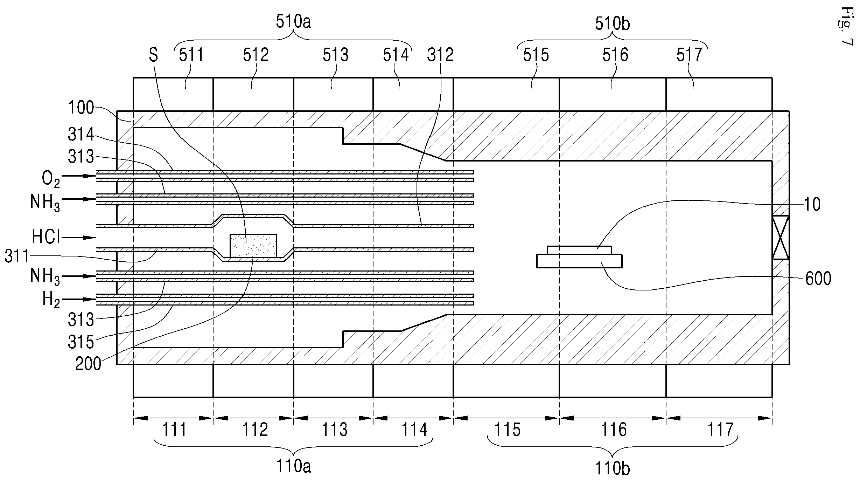

FIG. 7 is a view illustrating a growth apparatus configured to grow a nitride film on a substrate according to a method in accordance with still another exemplary embodiment;

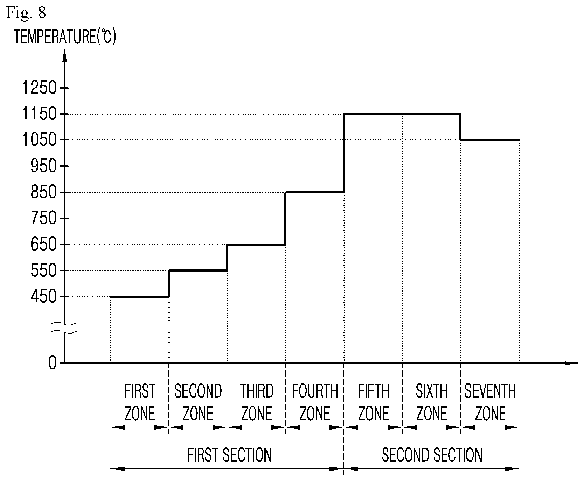

FIG. 8 is a graph showing the temperature of each of a plurality of zones inside a chamber when a nitride film is grown on a substrate according to a method in accordance with still another exemplary embodiment;

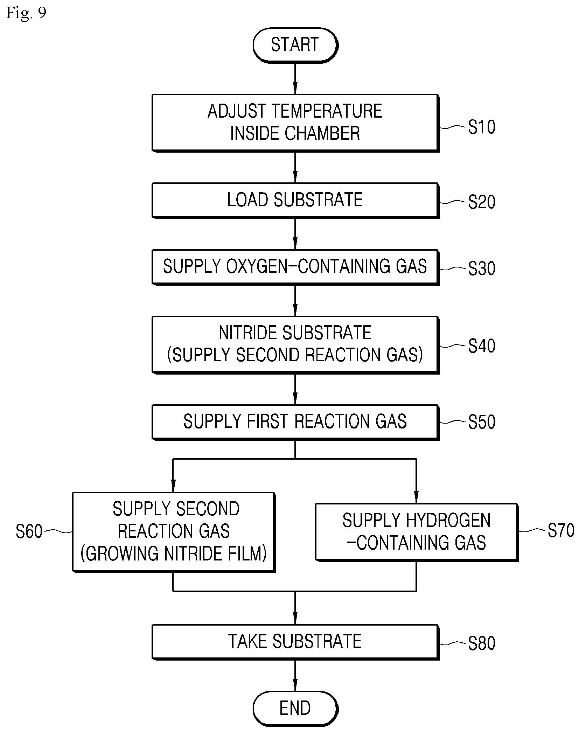

FIG. 9 is a view showing a method for growing a nitride film on a substrate according to a method in accordance with still another exemplary embodiment;

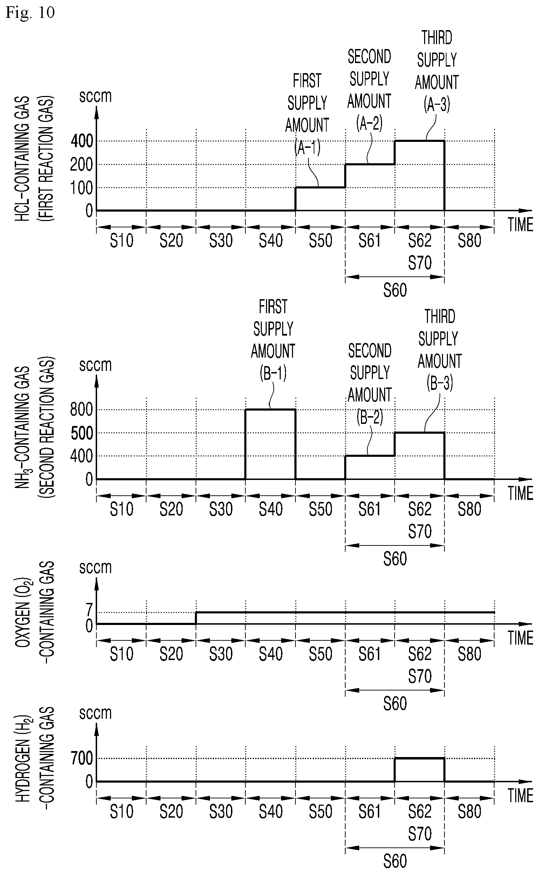

FIG. 10 is a conceptual view illustrating a method for supplying a gas into a chamber according to a method in accordance with still another exemplary embodiment;
(a) of FIG. 11 is a graph showing the thickness of an aluminum nitride (AlN) film in accordance with Experimental Examples 1 to 5;
(b) of FIG. 11 is a graph showing the full width at half maximum (FWHM) of an aluminum nitride (AlN) film in accordance with Experimental Examples 1 to 5;
(a) of FIG. 12 is a graph showing the thickness of an aluminum nitride (AlN) film in accordance with Experimental Examples 6 to 10;
(b) of FIG. 12 is a graph showing the full width at half maximum (FWHM) of an aluminum nitride (AlN) film in accordance with Experimental Examples 6 to 10;
(a) of FIG. 13 is a graph showing the thickness of an aluminum nitride (AlN) film in accordance with Experimental Examples 11 to 15; and
(b) of FIG. 13 is a graph showing the full width at half maximum (FWHM) of an aluminum nitride (AlN) film in accordance with Experimental Examples 11 to 15.

### DETAILED DESCRIPTION OF EMBODIMENTS

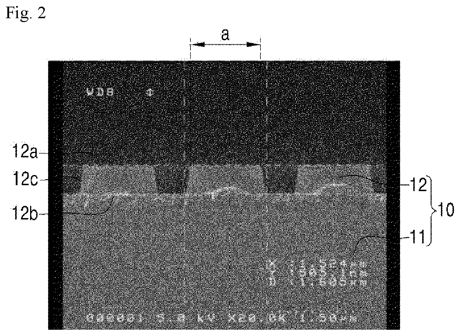

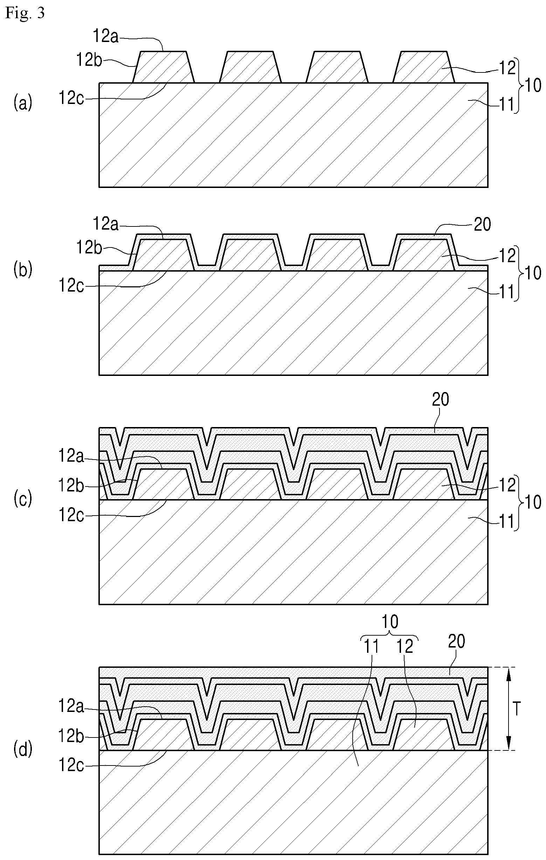

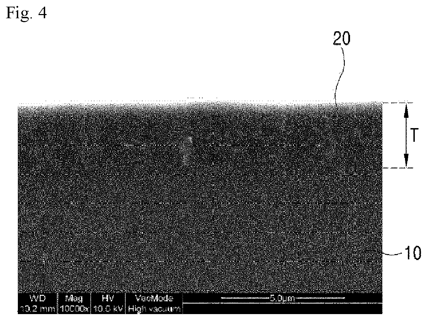

Hereinafter, exemplary embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. The drawings may be exaggerated in order to explain the exemplary embodiments, and like reference numerals in the drawings refer to like elements throughout.
(a) of FIG. 1 is a three-dimensional view illustrating a substrate in accordance with an exemplary embodiment. (b) of FIG. 1 is a cross-sectional view taken along A-A' of (a) of FIG. 1. FIG. 2 is a scanning electron microscope (SEM) photograph of a cross-section of a substrate in accordance with an exemplary embodiment. FIG. 3 is a view for describing a process in which a nitride film is grown on a substrate in accordance with an exemplary embodiment. FIG. 4 is a scanning electron microscope (SEM) photograph of a cross-section of a nitride film grown on a substrate in accordance with an exemplary embodiment.

A substrate 10 in accordance with an exemplary embodiment may be a sapphire substrate. In addition, the substrate 10 includes a plurality of protrusion portions 12, and may be a substrate in which the plurality of protrusion portions 12 are arranged in at least one direction to form a pattern. That is, the substrate 10 in accordance with an exemplary embodiment may be a substrate commonly referred to as a 'patterned sapphire substrate (PSS).'

As illustrated in (a) and (b) of FIG. 1, the substrate 10 includes a base 11 having a predetermined area and a predetermined thickness, and the plurality of protrusion portions 12 provided to protrude upward from the upper surface of the base 11.

The substrate 10 including the base 11 and the plurality of protrusion portions 12 formed to protrude from the base 11 may be prepared by using a base material containing sapphire (Al₂O₃) or made of sapphire (Al₂O₃).

A method for preparing the substrate 10 using a base material will be described later. Hereinafter, for the convenience of explanation, the base material containing sapphire (Al₂O₃) or made of sapphire (Al₂O₃) will be referred to as a 'sapphire base material.'

The base 11 may have, as illustrated in FIG. 1 for example, a quadrangular cross-sectional shape. That is, the base 11 may have a shape of being extended in a first direction (X-axis direction) and a second direction (Y-axis direction) which are horizontal directions, and being extended in a third direction (Z-axis direction) which is a vertical direction. In other words, the base 11 may have a quadrangular plate shape or a hexahedral shape having a length in the first direction (X-axis direction), a length in the second direction (Y-axis direction) which crosses or is orthogonal to the first direction (X-axis direction), and a length in the third direction (Z-axis direction) which is a vertical direction. The base 11 is not limited to the shape of the above-described example, and may be provided in a circular shape, an oval shape, a polygonal shape of a polygon having less than four sides, or a polygonal shape of a polygon having four sides or more.

Since the base 11 is provided using the sapphire base material, the base 11 may be the same as the material of the base material. That is, the base 11 may contain sapphire (Al₂O₃) or made of sapphire (Al₂O₃). In addition, the upper surface of the base 11 on which the protrusion portion 12 is formed may be the (0001) plane.

The protrusion portion 12 is provided to protrude upward from one surface of the base 11, for example, the upper surface. The protrusion portion 12 may be provided on the upper surface of the base 11 to have a predetermined area and a predetermined height. More specifically, the protrusion portion 12 may include a lower surface 12b in contact with or connected to the upper surface of the base 11, an upper surface 12a positioned above the lower surface 12b, and a side surface 12c connecting the lower surface 12b and the upper surface 12a.

In addition, the protrusion portion 12 may have, for example, the shape of a cylinder as illustrated in (a) of FIG. 1. Thus, the protrusion portion 12 may be provided such that the upper surface 12a and the lower surface 12b have a circular shape, and the side surface 12c has a curved shape to be extended around the circumference of the upper surface 12a and the lower surface 12b.

The upper surface 12a of the protrusion portion 12 may be provided as a plane having a predetermined area. That is, the upper surface 12a of the protrusion portion 12 may be provided as a plane parallel to the upper surface of the base 11. Here, when the upper surface 12a of the protrusion portion 12 is provided as a plane having a predetermined area, it may mean that a length a of the upper surface 12a is greater than 0 (a > 0).

More specifically, the upper surface 12a of the protrusion portion 12 may be provided such that the length thereof in each of the first direction (X-axis direction) and the second direction (Y-axis direction) is greater than 0. At this time, when the protrusion portion 12 has the shape of a cylinder, the upper surface 12a has a circular shape, so that the first direction (X-axis direction) and the second direction (Y-axis direction) of the upper surface 12a may be described as a diameter direction, and the length a of the upper surface 12a in each of the first direction (X-axis direction) and the second direction (Y-axis direction) may be the same.

In addition, the length a of the upper surface 12a of the protrusion portion 12 may be approximately 0.1 µm to approximately 2 µm (approximately 0.1 µm or greater to approximately 2 µm or less). More preferably, the length a of the upper surface 12a of the protrusion portion 12 may be approximately 1.3 µm to approximately 1.6 µm. Even more specifically, on the upper surface 12a of the protrusion portion 12, the length a in the first direction (X-axis direction) and the length a in the second direction (Y-axis direction) may each be approximately 0.1 µm to approximately 2 µm, more preferably approximately 1.3 µm to approximately 1.6 µm.

The reason that the protrusion portion 12 is provided such that the length a of the upper surface 12a is greater than 0 is to allow the upper surface 12a of the protrusion portion 12 to have the (0001) plane when a nitride film is grown.

Meanwhile, when a protrusion portion is provided in the shape of a cone, the upper surface of the protrusion portion does not have a length or an area (a=0). That is, the uppermost portion of the protrusion portion is not present in the shape of a face having an area. Accordingly, the protrusion portion in the shape of a cone does not have the (0001) plane. When a nitride film is grown on a substrate including a protrusion portion not having the (0001) plane, the nitride film needs to be formed thick to planarize the upper surface thereof. That is, in order to planarize the upper surface of the nitride film, which is a surface opposite to the upper surface of a base, the nitride film needs to be grown thick, and at this time, the required thickness of the nitride film may be approximately 8 µm or greater.

However, in the present disclosure, the protrusion portion 12 is provided such that the length a of the upper surface 12a is greater than 0. Thus, the protrusion portion 12 has the upper surface 12a which is the (0001) plane. When a nitride film is grown on the substrate 10 including the protrusion portion 12, it is possible to form the nitride film to be thin and to planarize the upper surface thereof compared to when a nitride film is grown on the substrate 10 provided with a protrusion portion in the shape of a cone (a=0). That is, in the present disclosure, even when a nitride film is formed thin to have a thickness of approximately 2 µm to approximately 4.5 µm, it is possible to planarize the upper surface of the nitride film.

As described above, the protrusion portion 12 may be provided in the shape of a cylinder including the upper surface 12a, the lower surface 12b, and the side surface 12c. At this time, the cylinder may have a diameter decreasing from the lower surface 12b toward the upper surface 12a. Thus, the length a of the upper surface 12a may be less than the length b of the lower surface 12b. In other words, the length b of the lower surface 12b may be greater than the length a of the upper surface 12a.

At this time, the length b of the lower surface 12b may be greater than approximately 0.1 µm to approximately 2 µm or less, and may be greater than the length a of the upper surface 12a in the above range (greater than approximately 0.1 µm to approximately 2 µm or less). Thus, the shape of a cross-section of the protrusion portion 12 may be a trapezoidal shape as illustrated in (b) of FIG. 1.

In the above, the protrusion portion 12 in which the length b of the lower surface 12b is greater than the length a of the upper surface 12a has been described. However, the exemplary embodiment is not limited thereto. The length a of the upper surface 12a and the length b of the lower surface 12b may be the same. At this time, the length b of the lower surface 12b of the protrusion portion 12 may be approximately 0.1 µm to approximately 2 µm (approximately 0.1 or greater to approximately 2 µm or less).

The protrusion portion 12 is provided in plurality. In addition, the plurality of protrusion portions 12 are arranged in an extension direction of the base 11 and formed spaced apart from each other as shown in (a) of FIG. 1. That is, the protrusion portion 12 may be arranged in the first direction (X-axis direction) and the second direction (Y-axis direction) of the base 11 and formed spaced apart from each other. Thus, upper surfaces 12a of the plurality of protrusion portions 12 may be spaced apart or separated from each other as shown in FIG. 1.

Hereinafter, a method for preparing a substrate in accordance with an exemplary embodiment as illustrated in (a) and (b) of FIG. 1 will be briefly described. At this time, a method for preparing a substrate by a photolithography method will be described in an exemplary embodiment.

First, a sapphire base material is prepared. Then, photoresist (PR) is applied on the upper surface of the base material. Next, a shadow mask is disposed above the base material applied with the photoresist. At this time, the shadow mask may have a shape, for example, in which a portion in which a protrusion portion is to be formed on the base material is closed and the other portions are open.

In addition, the shape of the closed region in the shadow mask may be circular. Thereafter, exposure is performed above the shadow mask, and then the photoresist is etched. At this time, the photoresist exposed by being exposed to the open region of the shadow mask is etched, and the photoresist facing the closed region remains. That is, the photoresist is patterned to remain in a portion in which a protrusion portion is to be formed on the upper surface of the base material. Next, the base material is dry-etched. At this time, a region in the base material not shielded by the photoresist pattern is etched. Next, the photoresist pattern is stripped.

Accordingly, as shown in (a) and (b) of FIG. 1, a substrate including a plurality of protrusion portions is prepared. That is, the substrate 10 including the base 11 and the plurality of protrusion portions 12 protruding upward from the upper surface of the base 11 and arranged spaced apart from each other is provided.

When a cross-section of the thus-prepared substrate 10 is photographed using a scanning electron microscope (SEM), an image, for example as shown in FIG. 2, may be obtained. As shown in FIG. 2, the plurality of protrusion portions 12 are provided on the upper surface of the base 11, and the length a of the upper surface 12a of the protrusion portion 12 is greater than 0 (a > 0). In addition, for example, the length of the upper surface 12a of the protrusion portion 12 may be greater than the length of the lower surface 12b, and thus, the shape of a cross-section of the protrusion portion 12 may be a trapezoidal shape as shown in FIG. 2.

The protrusion portion 12 may be provided such that the upper surface 12a has a predetermined area or the length of the upper surface 12a in each of the first and second directions (X-axis direction and Y-axis direction) is greater than 0 by adjusting at least one of the shape of the shadow mask, the type of photoresist, the exposure time and amount of light, and the etching conditions (etching material, time, etc.) of the base material in the state in which the photoresist pattern is formed.

When the substrate 10 is provided, a nitride film, for example an aluminum nitride (AlN) film, is grown on the substrate 10. More specifically, the aluminum nitride (AlN) film is grown using a source raw material containing Al, a first reaction gas containing HCl, a second reaction gas containing NH₃, a gas containing oxygen (O₂), and a gas containing hydrogen (H₂). At this time, the aluminum nitride (AlN) film may be grown using a hydride vapor phase epitaxy (HVPE) growth apparatus, and the growing method using the same will be described later.

When the substrate 10 including the plurality of protrusion portions 12 is provided, as described above, the aluminum nitride (AlN) film is grown on the substrate 10 using the source raw material containing Al, the first reaction gas containing HCl, the second reaction gas containing NH₃, the gas containing oxygen (O₂), and the gas containing hydrogen (H₂).

At this time, as illustrated in (a) of FIG. 3, the growing takes place on each of the upper surface of the base 11, the upper surface 12a of the protrusion portion 12, and the side surface 12c of the protrusion portion 12. In addition, as the growth time elapses, the thickness of the nitride film 20 increases.

At this time, as shown in (b) of FIG. 3 and (c) of FIG. 3, the upper surface of the nitride film may not be flat while the nitride film 20 is being grown. However, when the nitride film 20 is further grown, the upper surface thereof is planarized as shown in in (d) of FIG. 3 and FIG. 4. The thickness to which the upper surface of the nitride film is planarized may be (hereinafter, planarization thickness) may be approximately 4.5 µm or less, more specifically approximately 2 µm to approximately 4.5 µm (approximately 2 µm or greater to approximately 4.5 µm or less). Here, the thickness of the nitride film 20, that is, the planarization thickness means the length from the upper surface of the base 11 to the upper surface of the nitride film 20.

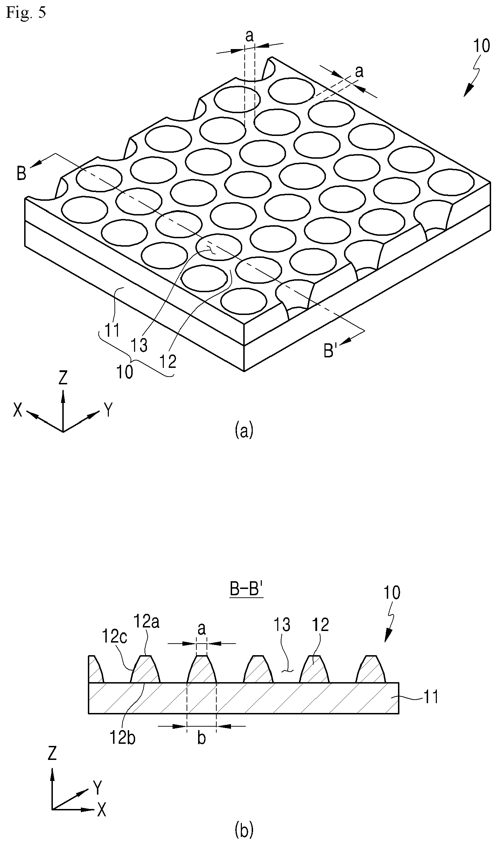

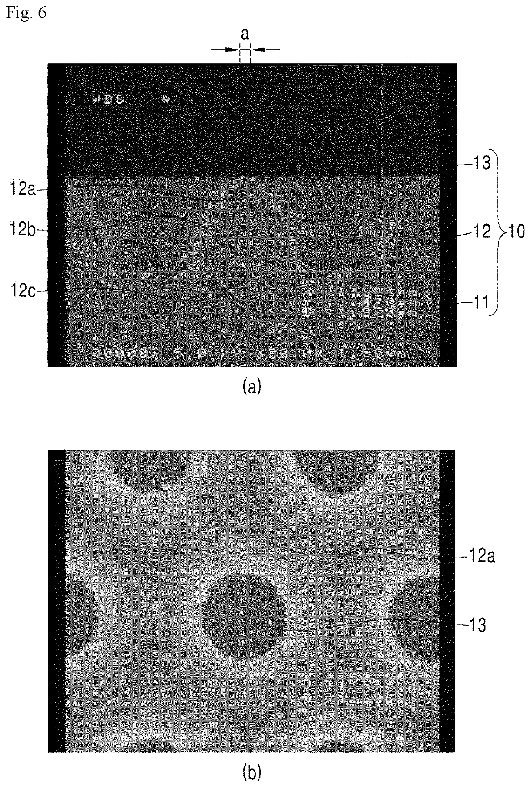

The upper surface of the nitride film 20 may be planarized by growing the nitride film 20 to a thickness of approximately 4.5 µm or less because the length a of the upper surface 12a of the protrusion portion 12 is provided to be greater than 0, thereby providing the protrusion portion to have the upper surface 12a, which is the (0001) plane, so that the nitride film 20 is grown on the (0001) plane.
(a) of FIG. 5 is a three-dimensional view illustrating a substrate in accordance with another exemplary embodiment. (b) of FIG. 5 is a cross-sectional view taken along B-B' of (a) of FIG. 5. (a) of FIG. 6 is a scanning electron microscope (SEM) photograph of a cross-section of a substrate in accordance with another exemplary embodiment. (b) of FIG. 6 is a scanning electron microscope (SEM) photograph taken from the above of a substrate in accordance with another exemplary embodiment.

In the above-described exemplary embodiment, the substrate 10 in which the plurality of protrusion portions 12 are provided spaced apart from each other, and thus, the upper surfaces 12a of the protrusion portions 12 are spaced apart or separated from each other has been described. However, the present disclosure is not limited thereto. As in another exemplary embodiment illustrated in (a) of FIG. 5, upper surfaces 12a of protrusion portions 12 may be provided to be connected to each other.

To describe a substrate 10 in accordance with another exemplary embodiment in more detail with reference to (a) and (b) of FIG. 5, the substrate 10 may include a base 11 having a predetermined area and a predetermined thickness, a plurality of holes 13 provided above the base 11 and disposed spaced apart from each other, and protrusion portions 12 provided on the upper surface of the base 11 to fill a gap between the plurality of holes 13.

The hole 13 may have a circular cross-sectional shape. In addition, the hole 13 may be provided in a shape in which the length or diameter thereof decreases downward as shown in (b) of FIG. 5.

The hole 13 is provided by etching a portion of a base material, and the protrusion portion 12 may be a portion surrounding the hole from the above of the base 11. Thus, each of the plurality of holes 13 may be described as being surrounded by a protrusion portion.

The protrusion portion 12 is provided to surround the hole 13 in an upper portion the base 11. Thus, the protrusion portion 12 is provided to have a predetermined area and a predetermined thickness. The protrusion portion 12 may include a lower surface 12b in contact with or connected to the upper surface of the base 11, an upper surface 12a positioned above the lower surface 12b, and a side surface 12c connecting the lower surface 12b and the upper surface 12a.

At this time, the lower surface 12b of the protrusion portion 12 may be a surface having the same height as a lower end portion of the hole 13, and the upper surface 12a of the protrusion portion 12 may be a surface having the same height as an upper end portion of the hole 13. In addition, the hole 13 is partitioned by the side surface 12c of the protrusion portion 12, and the hole 13 may be in a shape in which the length or diameter thereof decreases downward as described above. Thus, the side surface 12c of the protrusion portion 12 toward a hole may be provided in a curved surface as shown in (b) of FIG. 5.

In addition, the upper surface 12a of the protrusion portion 12 may be a plane having a predetermined area. That is, the upper surface 12a of the protrusion portion 12 may be provided as a plane parallel to the upper surface of the base 11, wherein the length a of the upper surface 12a may be greater than 0 (a > 0).

Here, the length a of the upper surface 12a of the protrusion portion 12 may at least mean the length between a hole 13 and a hole 13. Thus, when the length a of the upper surface 12a is greater than 0 (a > 0), it may mean that the length between the hole 13 and the hole 13 on the upper surface 12a of the protrusion portion 12 is greater than 0.

A region between the hole 13 and the hole 13 on the upper surface 12a of the protrusion portion 12 is provided to have a predetermined area. In other words, the region between the hole 13 and the hole 13 on the upper surface 12a of the protrusion portion 12 is provided such that the length a in each of the first direction (X-axis direction) and the second direction (Y-axis direction) is greater than 0. Even more specifically, in the region between the hole 13 and the hole 13 on the upper surface 12a of the protrusion portion 12, the length a in the first direction (X-axis direction) and the length a in the second direction (Y-axis direction) may each be approximately 0.1 µm to approximately 2 µm (approximately 0.1 µm or greater to approximately 2 µm or less), more preferably approximately 0.1 µm to approximately 0.5 µm.

As described above, on the upper surface 12a of the protrusion portion 12, the length a between the hole 13 and the hole 13 is provided to be greater than 0, so that an upper surface of the protrusion portion 12 on which a nitride film is to be formed may have the (0001) plane. Therefore, when a nitride film is grown on the substrate 10 having the protrusion portion 12, even when the nitride film is formed thin to have a thickness of approximately 2 µm to approximately 4.5 µm, it is possible to planarize the upper surface of the nitride film.

As described above, the hole 13 may be provided such that the diameter thereof decreases downward, and thus, on the lower surface 12b of the protrusion portion 12, a length b between a hole 13 and a hole 13 may be greater than the length a between the hole 13 and the hole 13 of the upper surface 12a. For example, on the lower surface 12b of the protrusion portion 12, the length b between the hole 13 and the hole 13 may be greater than approximately 0.1 µm to approximately 2 µm or less, and may be greater than the length a of the upper surface 12a in the above range (greater than approximately 0.1 µm to approximately 2 µm or less).

As described above, the substrate 10 in accordance with another exemplary embodiment includes the protrusion portions 12 provided to fill a gap between the plurality of holes 13 on the upper surface of the base 11. Thus, as illustrated in (a) of FIG. 5 and (b) of FIG. 6, on the upper surface 12a of the protrusion portion 12, the region between the hole 13 and the hole 13 is at least connected without being separated. More specifically, the protrusion portion 12 may be described as being continuously provided without being separated in the first direction (X-axis direction) and the second direction (Y-axis direction) except for a region in which the hole 13 is formed. Thus, the protrusion portion 12 may be described as one mass.

The substrate may be prepared by a photolithography method as described in the exemplary embodiment.

However, the substrate in accordance with another exemplary embodiment may use a shadow mask different from the shadow mask used when the substrate in accordance with an exemplary embodiment is prepared. That is, the shadow mask may be in a shape, for example, in which a portion in which a protrusion portion is to be formed on a base material is open end and the other portions are closed. In addition, the shape of the open region in the shadow mask may be circular.

Accordingly, the substrate 10 including the protrusion portions 12 provided to fill a gap between the plurality of holes is prepared as shown in (a) and (b) of FIG. 5.

When a cross-section of the thus-prepared substrate 10 is photographed using a scanning electron microscope (SEM), an image may be, for example, as shown in FIG. 6. Referring to (a) of FIG. 6, the protrusion portion 12 is provided to fill around the hole 13, and the upper surface 12a of the protrusion portion 12, that is, a gap between the hole 13 and the hole 13 may be provided as a plane having a predetermined area. That is, the length of the upper surface 12a of the protrusion portion 12 corresponding to the gap between the hole 13 and the hole 13 is greater than 0, and may be approximately 0.1 µm to approximately 0.5 µm. In addition, in the upper surface 12a of the protrusion portion 12, the region between a hole and a hole is connected without being separated as shown in (b) of FIG. 6.

FIG. 7 is a view illustrating a growth apparatus configured to grow a nitride film on a substrate according to a method in accordance with still another exemplary embodiment. FIG. 8 is a graph showing the temperature of each of a plurality of zones inside a chamber when a nitride film is grown on a substrate according to a method in accordance with still another exemplary embodiment.

The growth apparatus may be, for example, a hydride vapor phase epitaxy (HVPE) growth apparatus. As illustrated in FIG. 7, the growth apparatus may include a chamber 100 having a reaction space, a receiving part 200 installed inside the chamber 100 and having an internal space which receives a solid source raw material, a support 600 disposed in front of the receiving part 200 in the chamber 100 and on which a substrate 10 may be seated, a first pipe 311 connected to one end of the receiving part 200 to supply a first reaction gas to the receiving part 200, a second pipe 312 connected to the other end of the receiving part 200 to receive a gas generated in the receiving part 200, a third pipe 313 installed in the chamber 100 to supply a second reaction gas into the chamber 100, a fourth pipe 314 installed in the chamber 100 to supply a gas containing oxygen (O₂) into the chamber 100, a fifth pipe installed in the chamber 100 to supply a gas containing hydrogen (H₂) into the chamber 100.

In addition, the growth apparatus may include first and second heating parts 510a and 510b installed to surround the chamber 100 on the outside of the chamber 100.

First, the first and second heating parts 510a and 510b are described. The first and second heating parts 510a and 510b are means to heat the inside of the chamber 100, and each of the first and second heating parts 510a and 510b is installed to surround the chamber 100. In addition, the first and second heating parts 510a and 510b are installed in an extension direction of the chamber 100 as shown in FIG. 7, and the first and second heating parts 510a and 510b may be separately operated.

In addition, each of the first and second heating parts 510a and 510b is provided to include a plurality of heating elements. That is, the first heating part 510a includes a plurality of heating elements installed to be arranged in the extension direction of the chamber 100, and the plurality of heating elements may be separated operated. At this time, there may be provided four heating elements of the first heating part 510a, and the four heating elements 511 to 514 may be installed to be arranged in the extension direction of the chamber 100. In addition, the second heating part 510b includes a plurality of heating elements installed to be arranged in the extension direction of the chamber 100, and the plurality of heating elements may be separated operated. At this time, there may be provided, for example, three heating elements of the second heating part 510b, and the three heating elements 515 to 517 may be installed to be arranged in the extension direction of the chamber 100 on one side of the first heating part 510a.

Hereinafter, for the convenience of explanation, an example in which the first heating part 510a includes the four heating elements 511 to 514 and the second heating part 510b includes the three heating elements 515 to 517 will be described. In addition, the four heating elements 511 to 514 of the first heating part 510a will be referred to as first to fourth heating elements 511 to 514, and the three heating elements 515 to 517 of the second heating part 510b will be referred to as fifth to seventh heating elements 515 to 517.

As described above, using the installation positions of the first heating part 510a and the second heating part 510b which are disposed by being arranged in the extension direction of the chamber 100, the inside of the chamber 100 may be divided into two sections. That is, the inside of the chamber 100 may be divided into a first section 110a surrounded by the first heating part 510a and a second section 110b which is a region on one side of the first section 110a and surrounded by the section heating part 510b. At this time, the first section 110a and the second section 110b inside the chamber 100 are not spaced physically separated, but spaces in communication with or connected to each other.

In addition, as described above, the first heating part 510a includes the first to fourth heating elements 511 to 514 arranged in the extension direction of the chamber 100. Thus, the first section 110a inside the chamber 100 may be divided into a plurality of sections (hereinafter, zones) based on the positions of the first to fourth heating elements 511 to 514. That is, the first section 110a inside the chamber 100 may be divided into a first zone 111 surrounded by the first heating element 511, a second zone 112 surrounded by the second heating element 512, a third zone 113 surrounded by the third heating element 513, and a fourth zone 114 surrounded by the fourth heating element 514.

In addition, the second heating part 510b includes the fifth to seventh heating elements 515 to 517 arranged in the extension direction of the chamber 100. Thus, the second section 110b inside the chamber 100 may be divided into a fifth zone 115 surrounded by the fifth heating element 515, a sixth zone 116 surrounded by the sixth heating element 516, and a seventh zone 117 surrounded by the seventh heating element 517.

When the nitride film 20 is grown on the substrate 10 using the growth apparatus including the first and second heating parts 510a and 510b, temperature is adjusted according to the plurality of zones 111 to 117 described above.

For example, the temperature of the first section 110a inside the chamber 110 is adjusted to approximately 430°C to approximately 870°C using the first heating part 510a. At this time, as illustrated in FIG. 8, the temperature of the first section 110a may be adjusted to increase from the first zone 111 to the fourth zone 114. For example, the temperature of the first zone 111 may be adjusted to approximately 430°C to approximately 470°C, the temperature of the second zone 112 to approximately 530°C to approximately 570°C, the temperature of the third zone 113 to approximately 630°C to approximately 670°C, and the temperature of the fourth zone to approximately 830°C to approximately 870°C.

In addition, the temperature of the second section 110b may be adjusted to be higher than the temperature of the first section 110a, and may be adjusted to approximately 1030°C to approximately 1170°C. At this time, as shown in FIG. 8, the fifth zone 115 and the sixth zone 116 of the second section 110b may be adjusted to the same temperature, the seventh zone 117 may be adjusted to a temperature lower than those of the fifth and sixth zones 115 and 116. For example, the temperature of the fifth and sixth zones 115 and 116 may be adjusted to approximately 1130°C to approximately 1170°C, and the temperature of the seventh zone 117 may be adjusted to approximately 1030°C to approximately 1070°C.

In the internal space of the chamber 100 as described above, a nitride film is grown on the substrate 10 in the second section 110b, so that the second section 110b in which the substrate 10 is positioned may be referred to as a growth space.

Referring back to FIG. 7, the rest of the components of the growth apparatus will be described.

The support 600 is a means to support the substrate 10, and as illustrated in FIG. 7, may be installed to be positioned in the second section 110b inside the chamber 100. As a more specific example, the support 600 may be installed such that a portion thereof is positioned in the fifth zone 115, and the other portions are positioned in the sixth zone 116, or the entire support 600 may be installed to be positioned in the fifth zone 115 or the sixth zone 116.

The receiving part 200 is a means to receive a source raw material S therein, and may be in a cylindrical shape in which one end toward a first pipe 311 and the other end toward the support 600 are open. Thus, a gas provided from the first pipe 311 is introduced through an opening provided at one end of the receiving part 200, and a gas inside the receiving part 200 is introduced to the second pipe 312 through an opening provided at the other end thereof. The receiving part 200 may be installed to be positioned in the first section 110a as illustrated in FIG. 7. As a more specific example, the receiving part 200 may be installed to be positioned in the second zone 112. The receiving part 200, however, is not limited thereto, and may be installed such that a portion thereof is positioned in the second zone 112, and the other portions thereof are positioned in the third zone 113.

Each of the first to fifth pipes (311 to 315) may be a pipe in which a gas may pass through thereinside.

The first pipe 311 may be provided to be extended in the extension direction of the chamber 100, so as to be installed to be positioned in the first section 110a inside the chamber 100. At this time, an end of the first pipe 311 may be provided, for example, to protrude out of the chamber 100, and the end thereof may be, for example, connected to a first reaction gas storage part. In addition, the other end of the first pipe 311 may be connected to one end of the receiving part 200. Thus, a first reaction gas provided from the first reaction gas storage part, for example a gas containing HCl, may be introduced through an opening at one end of the first pipe 311, may pass through the inside of the first pipe 311, and then may be supplied into the receiving part 200 through an opening at the other end of the first pipe 311. As described above, when the first reaction gas is supplied to the first pipe 311, a carrier gas, for example, a nitrogen gas may be supplied theretogetherwith.

The second pipe 312 may be provided to be extended in the extension direction of the chamber 100, and one end thereof may be connected to the other end of the receiving part 200, and the other end thereof may be installed toward the second section 110b. At this time, the other end of the second pipe 312 may be installed to be positioned, for example, in the fifth zone 115 of the second section 110b. The second pipe 312, however, is not limited thereto, and the other end thereof may be installed to be positioned at a boundary between the fourth zone 114 and the fifth zone 115.

The third pipe 313 may be provided to be extended in a direction in which the first pipe 311, the receiving part 200, and the second pipe 312 are arranged and disposed. An end of the first pipe 313 may be provided to protrude out of the chamber 100, and the end thereof may be connected to a second reaction gas storage part. In addition, the other end of the third pipe 313 may be installed to be positioned, for example, in the fifth zone 115 of the second section 110b. The third pipe 313, however, is not limited thereto, and the other end of thereof may be installed to be positioned at a boundary between the fourth zone 114 and the fifth zone 115. Thus, a second reaction gas provided from the second reaction gas storage part, for example a gas containing NH₃, may be introduced through an opening at one end of the third pipe 313, may pass through the inside of the third pipe 313, and then may be discharged to the second section 110b through an opening at the other end of the third pipe 313. As described above, when the second reaction gas is supplied to the third pipe 313, a carrier gas, for example, a nitrogen gas may be supplied theretogetherwith.

The third pipe 313 may be provided in plurality, and as shown in FIG. 7, may be installed to be spaced apart having the first pipe 311, the receiving part 200, or the second pipe 312 interposed therebetween.

The fourth pipe 314 is a means to provide an oxygen-containing gas into the chamber 100, and may be provided to be extended in an extension direction of the third pipe 313. In addition, an end of the fourth pipe 314 may protrude out of the chamber 100 and be connected to an oxygen-containing gas storage part. In addition, the other end of the fourth pipe 314 may be installed to be positioned, for example, in the fifth zone 115 of the second 110b, or positioned at a boundary between the fourth zone 114 and the fifth zone 115.

The fifth pipe 315 is a means to provide a hydrogen-containing gas into the chamber 100, and may be provided to be extended in an extension direction of the fourth pipe 314. In addition, an end of the fifth pipe 315 may protrude out of the chamber 100 and be connected to a hydrogen-containing gas storage part. In addition, the other end of the fourth pipe 315 may be installed to be positioned, for example, in the fifth zone 115 of the second 110b, or positioned at a boundary between the fourth zone 114 and the fifth zone 115.

In the exemplary embodiments, when a nitride film is grown on a substrate, an oxygen-containing gas and a hydrogen-containing gas are additionally used other than a source gas, first and second reaction gases, and a carrier gas.

At this time, in the total gases supplied into the chamber 100, the volume ratio of the oxygen-containing gas and the volume ratio of the hydrogen-containing gas are controlled. That is, in the total gases supplied into the chamber 100, the oxygen-containing gas may be supplied in a volume ratio of approximately 0.01 vol% to approximately 0.1 vol%, preferably 0.03 vol% to 0.07 vol%. More preferably, the oxygen-containing gas may be supplied in a volume ratio of approximately 0.04 vol% to approximately 0.06 vol%. In addition, in the total gases supplied into the chamber 100, the hydrogen-containing gas may be supplied to a volume ratio of approximately 0.7 vol% to approximately 7 vol%, preferably 3.5 vol% to 7 vol%. Even more preferably, the hydrogen-containing gas may be supplied in a volume ratio of approximately 4.5 vol% to approximately 5.5 vol%.

As described above, even when a nitride film is formed thin to have a thickness of approximately 2 µm to approximately 4.5 µm, it is possible to planarize the upper surface of the nitride film by adjusting the ratio of each of the oxygen-containing gas and the hydrogen-containing gas which are supplied into the chamber 100.

Hereinafter, with reference to FIG. 7 to FIG. 10, a method for growing a nitride film on a substrate in accordance with still another exemplary embodiment will be described. At this time, an example in which aluminum nitride (AlN) is grown on a substrate will be described.

FIG. 9 is a view showing a method for growing a nitride film on a substrate according to a method in accordance with still another exemplary embodiment. FIG. 10 is a conceptual view illustrating a method for supplying a gas into a chamber according to a method in accordance with still another exemplary embodiment.

First, an inert gas, for example, a nitrogen gas, is supplied into the chamber 100. That is, the nitrogen gas, which is separate from the nitrogen gas supplied as a carrier gas when the first reaction gas and the second reaction gas are supplied, is supplied into the chamber 100. At this time, it is preferable that the nitrogen gas is supplied to the outside of the receiving part 200, and the first to fifth pipes 311 to 315 inside the chamber 100. In addition, the nitrogen gas may be continuously supplied while the growth apparatus is in operation.

Thereafter, the temperature inside the chamber 100 is adjusted (S10). That is, the first to fourth heating elements 511 to 514 of the first heating part 510a and the fifth to seventh heating elements 515 to 517 of the second heating element 510b are each separated operated to separately adjust the temperature of the first to seventh zones 111 to 117 inside the chamber 100. At this time, for example, as shown in FIG. 8, the temperature of the first zone 111 of the first section 110a may be adjusted to approximately 430°C to approximately 370°C, the temperature of the second zone 112 thereof to approximately 530°C to approximately 570°C, the temperature of the third zone 113 thereof to approximately 630°C to approximately 670°C, and the temperature of the fourth zone thereof to approximately 830°C to approximately 870°C. In addition, the temperature of the fifth and sixth zones 115 and 116 may be adjusted to approximately 1130°C to approximately 1170°C, and the temperature of the seventh zone 117 may be adjusted to approximately 1030°C to approximately 1070°C.

When the temperature adjustment inside of the chamber 100 is finished, the substrate 10 is loaded into the second section 110b of the chamber 100 (S20). That is, the substrate 10 is seated on the support 600 disposed across the fifth zone 115 and the sixth zone 116 of the second section 110b.

When the substrate 10 is loaded into the chamber 100, an oxygen-containing gas is started to be supplied into the chamber 100 (S30). To this end, when an oxygen-containing gas is introduced to the fourth pipe 314, the oxygen-containing gas moves through the fourth pipe 314 and is discharged to the second section 110b, for example, the fifth zone 115. The oxygen-containing gas discharged to the fifth zone 115 may be diffused to at least the fifth to seventh zones 515 to 517 of the second section 110b. The supply of the oxygen-containing gas to the second section 110b of the chamber 100 may continue from when the substrate 10 is charged into the chamber 100 and to when the growing of a nitride film (S60) is terminated. As another example, the oxygen-containing gas may be supplied only during the growing of a nitride film (S60: S61 and S62).

In addition, the oxygen-containing gas may be supplied in a volume ratio (vol%) of approximately 0.01 vol% to approximately 0.1 vol%, preferably approximately 0.03 vol% to approximately 0.07 vol%, more preferably approximately 0.04 vol% to approximately 0.06 vol% based on the volume of the total gases supplied into the chamber 100.

Next, the substrate 10 is nitrided (S40). To this end, a NH₃-containing gas, that is, a second reaction gas, is introduced to the third pipe 313.

The NH₃-containing gas (the second reaction gas) introduced to the third pipe 313 passes through the inside of the third pipe 313, and then is discharged to the fifth zone 115 of the second section 110b. At this time, by the second reaction gas discharged to the second section 110b, that is, the NH₃-containing gas, the substrate 10 is nitrided. The supply amount of the second reaction gas (hereinafter, a first supply amount B-1) supplied during the nitriding of the substrate 10, or the volume ratio, may be larger than second and third supply amounts B-2 and B-3 to be supplied during the growing of a nitride film later.

When the nitriding of the substrate 10 is terminated, the supply of the second reaction gas is stopped. Then, an HCl-containing gas, that is, a first reaction gas is supplied (S50). To this end, when a first reaction gas is introduced to the first pipe 311, the first reaction gas moves through the first pipe 311 and is introduced into the receiving part 200. The first reaction gas introduced into the receiving part 200 reacts with the source raw material S, that is, an Al metal, and by the reaction, an AlCl₃ gas is generated (refer to Reaction Formula 1). The AlCl₃ gas generated inside the receiving part 200 is discharged to the fifth zone 115 of the second section 110b through the second pipe 312 connected to the receiving part 200.

After the first reaction gas is started to be supplied, the second reaction gas is not supplied for a predetermined period of time, and the supply amount of the first reaction gas supplied at this time is referred to as a first supply amount A-1.

Reaction Formula 1 : Al(S) + 3HCl(g) --> AlCl₃(g) + 3/2H₂(g)

When the first reaction gas is supplied in the first supply amount A-1 for a predetermined period of time, the second reaction gas is started to be supplied to grow the nitride film 20 on the substrate 10 S60. More specifically, after the first reaction gas is supplied in the first supply amount A-1 for a predetermined period of time, the supply amount of the first reaction gas is increased to a second supply amount A-2, which is larger than the first supply amount A-1 (see S61 of FIG. 10). Then, when the first reaction gas is started to be supplied in the second supply amount A2, the second reaction gas is started to be supplied (see S61 of FIG. 10). At this time, the second reaction gas may be supplied in the second supply amount B-2, which is smaller than the first supply amount B-1 supplied during the nitriding of the substrate 10 (S40). In addition, after the first and second reaction gases are respectively supplied in the second supply amounts A-2 and B-2 for a predetermined period of time, the supply amounts of the first and second reaction gases are respectively increased to third supply amounts A-3 and B-3, which are larger than the second supply amounts A-2 and B-2 (see S62 of FIG. 10).

While the first reaction gas and the second reaction gas are supplied together as described above (S60: S61 and S62), the nitride film 20, that is, an aluminum nitride (AlN) film is grown on the substrate 10. That is, the AlCl₃ gas generated in the receiving part 200 is discharged through the second pipe 312 to the second section 110b, and the second reaction gas containing NH₃ is discharged through the third pipe 313 to the second section 110b. Thus, by the reaction between AlCl₃ and NH₃ in the second 110b, AlN(g) is generated (see Reaction Formula 2), and the generated AlN is formed as a film on the substrate 10.

Reaction Formula 2 : AlCl₃(g) + NH₃(g) --> AlN(g) + 3HCl

While the first reaction gas and the second reaction gas are supplied, a hydrogen(H₂)-containing gas is supplied through the fifth pipe 315 to the second section 110b of the chamber 100 (S70). At this time, the hydrogen-containing gas is supplied in a volume ratio of approximately 0.7 vol% to approximately 7 vol%, preferably approximately 3.5 vol% to approximately 7 vol%, more preferably approximately 4.5 vol% to approximately 5.5 vol% based on the volume of the total gases supplied into the chamber 100.

In addition, the hydrogen-containing gas may be supplied only in some intervals while a nitride film is grown on the substrate 10. In other words, among intervals in which the first reaction gas and the second reaction gas are supplied (S60: S61 and S62), the hydrogen-containing gas may be supplied only in some intervals. For example, when the first and second reaction gases are respectively supplied in the second supply amounts A-2 and B-2 (S61), the hydrogen-containing gas may not be supplied, but when the first and second reaction gases are respectively supplied in the third supply amounts A-3 and B-3 (S62), the hydrogen-containing gas may be supplied. On the contrary, when the first and second reaction gases are respectively supplied in the second supply amounts A-2 and B-2 (S61), the hydrogen-containing gas may be supplied, but when the first and second reaction gases are respectively supplied in the third supply amounts A-3 and B-3 (S62), the hydrogen-containing gas may not be supplied. As another example, when the first and second reaction gases are respectively supplied in the second supply amounts A-2 and B-2 and in the third supply amounts A-3 and B-3 (S61 and S62), the hydrogen-containing gas may be continuously supplied.

When a preset period of time elapses after the first and second reaction gases are started to be respectively supplied in the second supply amounts A-2 and B-2, the supply of each of the first reaction gas, the second reaction gas, and the hydrogen-containing gas is stopped to terminate the growing. At this time, the preset period of time may be determined according to a target thickness of the nitride film 20 to be formed on the base 11 of the substrate 10. In addition, the target thickness may be approximately 4.5 µm or less, more specifically approximately 2 µm to approximately 4.5 µm.

Thus, when the preset period of time elapses after the first and second reaction gases are started to be respectively supplied in the second supply amounts A-2 and B-2, the supply of each of the first reaction gas, the second reaction gas, and the hydrogen-containing gas is stopped and the substrate 10 is taken to the outside of the chamber 100 (S80).

When the growing of the nitride film is terminated as described above, an upper surface of the nitride film is polished by a chemical mechanical polishing (CMP) method.

The threading dislocation density (TDD) for the polished nitride film is approximately 5^{∗}10⁸ or less. That is, when a substrate in accordance with the exemplary embodiments is used and when a nitride film grown by the growing method in accordance with the exemplary embodiments is polished, the threading dislocation density (TDD) of the nitride film as low as approximately 5^{∗}10⁸ or less.

In the above, the forming of an AlN film has been described in forming a nitride film on the substrate 10, but the present disclosure is not limited thereto, and various nitride films may be formed. For example, a gallium nitride (GaN) film may be formed. In this case, a source raw material charged into the receiving part 200 may be a Ga metal.
(a) of FIG. 11 is a graph showing the thickness of an aluminum nitride (AlN) film in accordance with Experimental Examples 1 to 5, and (b) of FIG. 11 is a graph showing the full width at half maximum (FWHM) of an aluminum nitride (AlN) film in accordance with Experimental Examples 1 to 5.

Experimental Examples 1 to 5 show a case in which an AlN film was grown on a plane substrate not including the protrusion portion 12 and the hole 13. In addition, in Experimental Examples 1 to 5, a first reaction gas containing HCl and a second reaction gas containing NH₃ were supplied into the chamber 100, and a hydrogen-containing gas was not supplied thereinto. In addition, in Experimental Example 1, an oxygen-containing gas was not supplied, and in each of Experimental Examples 2 to 5, an oxygen-containing gas was supplied to form an AlN film. At this time, in various types of gases supplied into the chamber, the oxygen-containing gas was supplied in a volume ratio (vol%) of approximately 0.015 vol% (2 sccm) in Experimental Example 2, approximately 0.037 vol% (5 sccm) in Experimental Example 3, approximately 0.052 vol% (7 sccm) in Experimental Example 4, and approximately 0.067 vol% (9 sccm) in Experimental Example 5 to form the AlN film.

In (a) of FIG. 11, the thickness of the AlN film in accordance with Experimental Examples 1 to 5 is a thickness to which an upper surface of the AlN film (top surface) is planarized. In addition, a distance between an upper surface of the plain substrate not including the protrusion portion 12 and the hole 13 and the upper surface of the AlN film was measured as a thickness.

The full width at half maximum in (b) of FIG. 11 is a full width at half maximum (FWHM)(arcsec) of a 102 crystal surface of the AlN film in accordance with Experimental Examples 1 to 5 measured using an X-ray differactometer (XRD). That is, in the X-ray diffraction spectrum, the half (1/2) of a peak width for the 102 surface is the full width at half maximum (FWHM). It can be interpreted that the smaller the half width, the smaller the threading dislocation density (TDD), and the better the crystallinity of a nitride film.

Referring to (a) of FIG. 11, the thickness of the AlN film in accordance with each of Experimental Examples 2 to Experimental Example 5 is less than the thickness of the AlN film in accordance with Experimental Example 1. In other words, the planarization thickness of the AlN film in accordance with each of Experimental Examples 2 to Experimental Example 5 in which an oxygen-containing gas was used is less than the planarization thickness of the AlN film in accordance with Experimental Example 1 in which an oxygen-containing gas was not used.

In addition, referring to (b) of FIG. 11, the full width at half maximum of the AlN film in accordance with each of Experimental Examples 2 to Experimental Example 5 is less than the full width at half maximum of the AlN film in accordance with Experimental Example 1. That is, compared to the AlN film of Experimental Example 1 in which an oxygen-containing gas was not used, the AlN film of each of Experimental Examples 2 to Experimental Example 5 has a small threading dislocation density and excellent crystallinity of a nitride film.

From the above experimental results, it can be seen that when an oxygen-containing gas is supplied together with first and second reactive gases, even when a nitride film, that is, an AlN film, is formed thin, it is possible to planarize the upper surface thereof. That is, it can be seen that the planarization thickness of an AlN film may be formed thin when an oxygen-containing gas is used compared to when an oxygen-containing gas is not used. In addition, it can be seen that when an oxygen-containing gas is used, the threading dislocation density of an AlN film is small, and the crystallinity of the nitride film is improved compared to when an oxygen-containing gas is not used.
(a) of FIG. 12 is a graph showing the thickness of an aluminum nitride (AlN) film in accordance with Experimental Examples 6 to 10, and (b) of FIG. 12 is a graph showing the full width at half maximum (FWHM) of an aluminum nitride (AlN) film in accordance with Experimental Examples 6 to 10.

As shown in Experimental Examples 1 to 5, Experimental Examples 6 to 10 show a case in which an AlN film was grown on a plane substrate not including the protrusion portion 12 and the hole 13.

In addition, in Experimental Examples 6 to 10, a first reaction gas containing HCl and a second reaction gas containing NH₃ were supplied into the chamber 100, and an oxygen-containing gas and a hydrogen-containing gas were also supplied theretogether to form an AlN film.

At this time, in each of Experimental Examples 6 to 10, the oxygen-containing gas was supplied in the same amount and the hydrogen-containing gas was supplied in different supply amounts. That is, in the total gases supplied into a chamber, the oxygen-containing gas was supplied in a volume ratio of approximately 0.052 vol% in each of Experimental Examples 6 to 10. In addition, in various types of gases supplied into the chamber, the hydrogen-containing gas was supplied in a volume ratio (vol%) of approximately 0.74 vol% (100 sccm) in Experimental Example 6, approximately 2.22 vol% (300 sccm) in Experimental Example 7, approximately 3.70 vol% (500 sccm) in Experimental Example 8, approximately 5.18 vol% (700sccm) in Experimental Example 9, and approximately 6.66 vol% (900 sccm) in Experimental Example 10 to form the AlN film.

As described with reference to (a) of FIG. 11, the thickness of the AlN film in (a) of FIG. 12 is a thickness to which an upper surface of the AlN film (top surface) is planarized. In addition, the full width at half maximum in (b) of FIG. 12 was measured in the same manner as described with reference to (b) of FIG. 11.

Referring to (a) of FIG. 12, as the volume ratio of the hydrogen-containing gas increases, the thickness to which the AlN film is planarized decreases. That is, the planarization thickness of the AlN film decreases from Experimental Example 6 to Experimental Example 10.

In addition, as shown in (b) of FIG. 12, as the volume ratio of the hydrogen-containing gas increases in the range of 5.18 vol% (700 sccm) or less, the full width at half maximum (arcsec) decreases. In other words, as the volume ratio of the hydrogen-containing gas increases in the range of 5.18 vol% (700 sccm) or less, the threading dislocation density of the AlN film is small and the crystallinity is excellent. In addition, the full width at half maximum of Experimental Example 10 is larger than the full width at half maximum of Experimental Example 9, but smaller than that of each of Experimental Examples 6 to 8.

From the above, it can be seen that by controlling the volume ratio of a hydrogen-containing gas, that is, the supply amount thereof, the thickness to which an AlN film is planarized, the threading dislocation density, and the crystallinity may be controlled.
(a) of FIG. 13 is a graph showing the thickness of an aluminum nitride (AlN) film in accordance with Experimental Examples 11 to 15, and (b) of FIG. 13 is a graph showing the full width at half maximum (FWHM) of an aluminum nitride (AlN) film in accordance with Experimental Examples 11 to 15.

Experimental Examples 11 to 15 are cases in which an AlN film was grown on the substrate in accordance with an exemplary embodiment illustrated in (a) and (b) of FIG. 1. That is, the substrate used in each of Experimental Examples 11 to 15 includes the base 11 and the plurality of protrusion portions 12 protruding upward from up upper surface of the base 11 as shown in in FIG. 1. In addition, a length a of an upper surface of the protrusion portion 12 is greater than 0 (a > 0). In other words, on the upper surface 12a of the protrusion portion 12, the length a in each of the first direction (X-axis direction) and the second direction (Y-axis direction) is greater than 0. Thus, the upper surface of the protrusion portion 12 has a predetermined area, and accordingly, the upper surface of the protrusion portion 12 has the (0001) plane.

In addition, in Experimental Examples 11 to 15, a gas was supplied under the same conditions used in Experimental Examples 6 to 10 described above to form an AlN film. In other words, in Experimental Examples 11 to 15, a first reaction gas containing HCl and a second reaction gas containing NH₃ were supplied into a chamber and an oxygen-containing gas and a hydrogen-containing gas were also supplied theretogether to form an AlN film.

At this time, in the total gases supplied into a chamber, the oxygen-containing gas was supplied in the same volume ratio of approximately 0.052 vol% and the hydrogen-containing gas was supplied in different volume ratios in each of Experimental Examples 11 to 15. That is, the hydrogen-containing gas was supplied in a volume ratio of approximately 0.74 vol% (100 sccm) in Experimental Example 11, approximately 2.22 vol% (300 sccm) in Experimental Example 12, approximately 3.70 vol% (500 sccm) in Experimental Example 13, approximately 5.18 vol% (700sccm) in Experimental Example 14, and approximately 6.66 vol% (900 sccm) in Experimental Example 15 to form the AlN film.

In addition, for each of the AlN films in accordance with Experimental Examples 11 to 15, the planarization thickness and the full width at half maximum were measured. At this time, the thickness of the AlN film is a distance between the upper surface of the base and an upper surface of the AlN film.

Referring to (a) of FIG. 13, the planarization thickness of the AlN film in accordance with each of Experimental Examples 13 to 15 is less than the thickness of the AlN film in accordance with each of Experimental Examples 11 and 12. That is, the planarization thickness of each of Experimental Examples 13 to 15 in which the hydrogen-containing gas is supplied in approximately 3.5 vol% or greater is less than the planarization thickness of each of Experimental Examples 11 and 12 in which the hydrogen-containing gas is supplied in less than approximately 3.5 vol%.

In addition, referring to (b) of FIG. 13, the full width at half maximum of each of Experimental Examples 11 to 15 is as small as approximately 570 arcsec or less, that is approximately 430 arcsec to approximately 570 arcsec. In addition, the full width at half maximum of the AlN film in accordance with each of Experimental Examples 13 to 15 is smaller than the full width at half maximum of the AlN film in accordance with each of Experimental Examples 11 and 12. That is, the full width at half maximum of each of Experimental Examples 13 to 15 in which the hydrogen-containing gas is supplied in approximately 3.5 vol% or greater is smaller than the full width at half maximum of each of Experimental Examples 11 and 12 in which the hydrogen-containing gas is supplied in less than approximately 3.5 vol%. From the above, it can be seen that in supplying the hydrogen-containing gas in a volume ratio of approximately 0.7 vol% to approximately 7 vol%, it is more preferable to supply the hydrogen-containing gas in a volume ratio of approximately 3.5 vol% or greater to approximately 7 vol% or less. That is, it can be seen that the threading dislocation density may be more effectively decreased, and the crystallinity may be improved when the hydrogen-containing gas is supplied in a volume ratio of 3.5 vol% or greater to approximately 7 vol% or less compared to supplying the hydrogen-containing gas in a volume ratio of approximately 0.7 vol% to approximately 7 vol%.

As described above, in accordance with the exemplary embodiments, the substrate 10 is prepared to have the protrusion portion 12 in which the length a of the upper surface 12a thereof is greater than 0. That is, when the substrate 10 including the protrusion portion 12 is prepared, the protrusion portion 12 is prepared to have the upper surface 12a with a predetermined area. In addition, in forming the nitride film 20 on the substrate 10, an oxygen-containing gas and a hydrogen-containing gas are additionally supplied in addition to a source gas, and first and second reaction gases to form the nitride film.

Accordingly, even when the nitride film 20 is formed thin to have a thickness of approximately 2 µm to approximately 4.5 µm, it is possible to planarize the upper surface of the nitride film. That is, even when a nitride film is formed thin, it is possible to planarize the upper surface of the nitride film such that the full width at half maximum is approximately 570 arcsec or less. Accordingly, it is possible to reduce process time required to grow or form the nitride film until the upper surface thereof is planarized, and thus, there is an effect of improving the production rate.

According to exemplary embodiments, even when a nitride film is formed thin, it is possible to planarize the upper surface of the nitride film. Accordingly, it is possible to reduce process time required to grow or form the nitride film until the upper surface thereof is planarized, and thus, there is an effect of improving the production rate.

Although the method for growing nitride film has been described with reference to the specific embodiments, it is not limited thereto. Therefore, it will be readily understood by those skilled in the art that various modifications and changes can be made thereto without departing from the spirit and scope of the present invention defined by the appended claims.

## Claims

1. A method for growing a nitride film, the method comprising:
charging a substrate into a growth space; and
growing a nitride film on the substrate, wherein the growing of a nitride film includes:
reacting a first reaction gas with a source raw material and supplying a generated gas to the growth space;
supplying a second reaction gas to the growth space; and
supplying an oxygen-containing gas and a hydrogen-containing gas to the growth space.

2. The method of claim 1, further comprising:
adjusting the temperature inside the growth space before the charging of a substrate into the growth space; and
supplying the second reaction gas to the growth space in a first supply amount to nitride the substrate before the growing of a nitride film.

3. The method of claim 2, further comprising:
in the reacting of the first reaction gas with the source raw material, supplying the first reaction gas into a receiving part which is installed on one side of the growth space and in which the source raw material is received; and
supplying the first reaction gas to the receiving part in a first supply amount before the growing of a nitride film.

4. The method of claim 3, wherein in the growing of a nitride film, the supplying of the first reaction gas to the receiving part comprises:
supplying the first reaction gas in a second supply amount greater than the first supply amount; and
supplying the first reaction gas in a third supply amount greater than the second supply amount.

5. The method of claim 2, wherein in the growing of a nitride film, the supplying of the second reaction gas to the growth space comprises:
supplying the second reaction gas in a second supply amount less than the first supply amount; and
supplying the second reaction gas in a third supply amount less than the first supply amount and greater than the second supply amount.

6. The method of claim 2, wherein, in the supplying of the oxygen-containing gas to the growth space, the volume ratio of the oxygen-containing gas in the total volume of gases supplied to the growth space is approximately 0.01 vol% to approximately 0.1 vol%.

7. The method of claim 6, wherein, in the supplying of the oxygen-containing gas to the growth space, the oxygen-containing gas is supplied from the start of the charging of the substrate to the growth space to the end of the growing of the nitride film.

8. The method of claim 7, wherein, in the supplying of the oxygen-containing gas to the growth space, the oxygen-containing gas is supplied in the same amount from the start of the charging of the substrate to the growth space to the end of the growing of the nitride film.

9. The method of claim 2, wherein, in the supplying of the hydrogen-containing gas to the growth space, the volume ratio of the hydrogen-containing gas in the total volume of gases supplied to the growth space is approximately 0.7 vol% to approximately 7 vol%.

10. The method of claim 5, wherein, in the supplying of the hydrogen-containing gas to the growth space, when the second reaction gas is supplied to the growth space in the third supply amount, the hydrogen-containing gas is supplied to the growth space.

11. The method according to any one of claim 1 to claim 10, wherein the preparing of the substrate comprises manufacturing a substrate including a base and a plurality of protrusion portions which protrude upward from the base, wherein an upper surface of the protrusion portion, which is a surface opposite to the base, has a length greater than 0.

12. The method according to any one of claim 1 to claim 10, wherein the preparing of the substrate comprises manufacturing a substrate including a base, a plurality of holes disposed spaced apart from each other above the base, and protrusion portions provided above the base to fill a gap between the plurality of holes, wherein on an upper surface of the protrusion portion, which is a surface opposite to the base, the length between the holes is at least greater than 0.

13. The method according to any one of claim 1 to claim 10, wherein:
the nitride film comprises any one of AIN and GaN films;
the first reaction gas contains HCl, and the second reaction gas contains NH₃; and
the source raw material comprises any one of a metal containing Al and a metal containing Ga.

14. The method according to any one of claim 1 to claim 10, wherein the nitride film is grown to have a thickness of approximately 2 µm to approximately 4.5 µm.
